(19) Europäisches Patentamt

European Patent Office

Office européen des brevets

(11) Veröffentlichungsnummer: **0 352 857 B1**

(12) **EUROPÄISCHE PATENTSCHRIFT**

(45) Veröffentlichungstag der Patentschrift: **06.10.93**

(51) Int. Cl.⁵: **C30B 25/06**, C30B 29/28, C23C 14/08

(21) Anmeldenummer: **89201929.0**

(22) Anmeldetag: **24.07.89**

(54) **Verfahren zur Herstellung von Eisengranatschichten.**

(30) Priorität: **29.07.88 DE 3825788**

(43) Veröffentlichungstag der Anmeldung:
**31.01.90 Patentblatt 90/05**

(45) Bekanntmachung des Hinweises auf die
Patenterteilung:
**06.10.93 Patentblatt 93/40**

(84) Benannte Vertragsstaaten:
**DE FR GB NL**

(56) Entgegenhaltungen:
**EP-A- 0 252 536**
**DE-A- 1 940 640**

**JOURNAL OF APPLIED PHYSICS, Band 57,
Nr. 8, Teil 2B, 15 April 1985, Woodbury, NY
(US); J.-P.KRUMME et al., Seiten
3885-3887&NUM;**

(73) Patentinhaber: **Philips Patentverwaltung
GmbH
Wendenstrasse 35c
D-20097 Hamburg(DE)**
(84) Benannte Vertragsstaaten:
**DE**

(73) Patentinhaber: **N.V. Philips' Gloeilampenfabrieken
Groenewoudseweg 1
NL-5621 BA Eindhoven(NL)**
(84) Benannte Vertragsstaaten:
**FR GB NL**

(72) Erfinder: **Doormann, Volker
Borchertring 27
D-2000 Hamburg 60(DE)**
Erfinder: **Krumme, Jens-Peter, Dr.
Sülldorfer Heideweg 4
D-2000 Hamburg 55(DE)**
Erfinder: **Radtke, Wolfgang
Hackendohrredder 13
D-2409 Scharbeutz 2(DE)**

(74) Vertreter: **Kupfermann, Fritz-Joachim,
Dipl.-Ing. et al
Philips Patentverwaltung GmbH
Wendenstrasse 35
Postfach 10 51 49
D-20035 Hamburg (DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services
(3. 10/3.6/3.3. 1)

**Beschreibung**

Die Erfindung betrifft ein Verfahren zur Herstellung von Eisengranatschichten mit in geringer Schwankungsbreite reproduzierbar eingestellten Brechungsindices n und Gitterkonstanten $a_O$, wobei die Schichten mittels HF-Kathodenzerstäubung unter Verwendung eines überwiegend eine Eisengranatphase neben Restphasen nahezu gleicher Zerstäubungsrate enthaltenden Targets in einem Edelgasplasma einer Ionenenergie der die anwachsende Schicht bombardierenden Ionen von kleiner als $10^2$ eV und eines Drucks im Bereich von 0,1 bis 2,0 Pa auf einem Substrat abgeschieden werden.

Ein derartiges Verfahren ist aus der europäischen Patentanmeldung mit der Veröffentlichungsnummer 0 252 536 A1 bekannt. Schichten, die nach dem bekannten Verfahren hergestellt werden, werden zum Aufbau von optischen Wellenleitern für nicht-reziproke optische Bauelemente eingesetzt. Mit dem bekannten verfahren ist es insbesondere möglich, den Brechungsindex n der abgeschiedenen Schichten um bis zu 0,7% durch Variation des Gasdrucks des Plasmas im Bereich von 0,3 bis 0,8 Pa zu verändern, wobei sich die Werte für die Brechungsindices und für die Gitterkonstanten mit zunehmendem zum Gasdruck vermindern. Es wird angenommen, daß die Abhängigkeit des Brechungsindex n vom Druck des Plasmas, z.B. ein Argon-Plasma, im wesentlichen eine Folge der Änderung des Beschusses der anwachsenden Schicht durch niederenergetische Ionen, hier Argonionen, ist. Als Folge der unterschiedlichen Rückstäubungsraten der am Schichtaufbau beteiligten Elemente ändert sich die Zusammensetzung der hergestellten Schicht und damit ändert sich auch der jeweilige Wert für den Brechungsindex n und für die Gitterkonstante $a_o$.

In der Praxis hat sich nun gezeigt, daß eine größere Variationsbreite der Werte für den Brechungsindex n und die Gitterkonstante $a_o$ der abgeschiedenen Schichten erwünscht ist, z.B., um die optische Anpassung von Teilschichten einer Wellenleiterstruktur zu ermöglichen. Dies ist insbesondere von Bedeutung, wenn mehrere Targets zur Herstellung einer Wellenleiterstruktur eingesetzt werden sollen.

Der Erfindung liegt daher die Aufgabe zugrunde, das eingangs genannte Verfahren so zu verbessern, daß die Werte für den Brechungsindex n und die Gitterkonstante $a_o$ vonmittels HF-Kathodenzerstäubung hergestellten Eisengranatschichten in einem größeren Bereich reproduzierbar auf einen definierten Wert eingestellt werden können.

Diese Aufgabe wird erfindungsgemäß dadurch gelöst, daß das Edelgas mit bis zu 5 Vol.% mindestens eines reaktiven Gases dotiert wird.

Nach einer vorteilhaften Weiterbildung des erfindungsgemäßen Verfahrens wird das Edelgas mit bis zu 2 Vol.% mindestens eines reaktiven Gases dotiert.

Nach einer vorteilhaften weiteren Ausgestaltung des Verfahrens der Erfindung wird als Edelgas Argon eingesetzt. Ist ein Argonplasma z.B. mit bis zu 5 Vol.% mit Sauerstoff als reaktives Gas dotiert, ergibt sich der Vorteil, daß z.B. bei einem konstanten Gesamtgasdruck von vorzugsweise 0,6 Pa die Werte für den Brechungsindex n der abgeschiedenen Schichten um bis zu 0,7% bei einer Reproduzierbarkeit von besser als ± 0,02% verändert werden können.

Die gleichzeitige Variation des Gesamtgasdrucks im Bereich von 0,3 bis 1,0 Pa und des Sauerstoffanteils im Plasma im Bereich von 0 bis 2 Vol.% führt zu einer reproduzierbaren Änderung des Brechungsindex bis zu 1,5% bei einkristallinen Eisengranatschichten und bis zu 2% bei nichtkristallinen, z.B. amorphen oder röntgenamorphen, Eisengranatschichten.

Ist ein Argon-Plasma eines Gesamtgasdruckes $p_{ges}$ = 0,6 Pa z.B. mit bis zu 2 Vol.% Wasserstoff als reaktives Gas dotiert, ergibt sich der Vorteil, daß der Brechungsindex n einkristalliner Eisengranatschichten um bis 1,5% und der Brechungsindex n nicht-kristalliner, z.B. amorpher oder röntgenamorpher, Eisengranatschichten um bis 1 % verändert wird.

Ebenso können die Werte für die Gitterkonstante $a_o$ einer einkristallin abgeschiedenen Schicht über den Gesamtgasdruck und die Dotierung des Plasmas mit einem reaktiven Gas gesteuert werden.

Nach weiteren vorteilhaften Ausgestaltungen des Verfahrens nach der Erfindung wird als Edelgas eine Mischung aus Edelgasen jeweils unterschiedlicher Massenzahl eingesetzt, insbesondere werden Mischungen aus Argon und Krypton oder aus Argon und Krypton und Xenon eingesetzt. Wie aus EP-A-0 252 536 bekannt ist, läßt sich durch Variation des Drucks eines Argon-Plasmas im Bereich von 0,1 bis 2,0 Pa eine reproduzierbare Änderung der Werte für den Brechungsindex n und die Gitterkonstante $a_o$ einer einkristallin abgeschiedenen Eisengranatschicht erreichen.

Für z.B. die Anpassung von Schichten eines mehrschichtigen optischen Wellenleiters ist die Erweiterung des Einstellbereiches der Werte für den Brechungsindex n und die Gitterkonstante $a_o$ von Eisengranatschichten gegenüber den in einem reinen Argon-Plasma erreichbaren Werten wünschenswert. Dies kann vorteilhafterweise ohne Wechsel des Targets, aus dem die Eisengranatschichten abgeschieden werden, erreicht werden, wenn Argon je nach den gewünschten Werten für den Brechungsindex n und gegebenen-

falls die Gitterkonstante $a_o$ der abzuscheidenden Schichten ganz oder teilweise durch Krypton oder durch Xenon oder durch Krypton und Xenon ersetzt wird. Es wird angenommen, daß dieser Effekt darauf beruht, daß die Wahrscheinlichkeit der Reflexion von auf ein Eisengranat-Target auftreffenden Argonionen größer ist, als die von Kryptonionen und von Xenonionen, weil die Massenzahl von Argon kleiner und die Massenzahl jeweils von Krypton und von Xenon größer sind als die mittlere Atommasse von Eisengranat. Am Target reflektierte energetische Edelgasatome führen zur Bombardierung der auf dem Substrat anwachsenden Schicht und damit zur Rückstäubung von Schichtbestandteilen mit niedriger Zerstäubungsrate, was eine Änderung der Zusammensetzung der abgeschiedenen Schichten und damit eine Änderung des jeweiligen Brechungsindex n und der jeweiligen Gitterkonstante $a_o$ zur Folge hat, ohne daß das kristalline Wachstum der anwachsenden Schicht gestört wird.

Untersuchungen im Rahmen des vorliegenden Verfahrens haben gezeigt, daß Krypton-Plasmen eines Gesamtdrucks von 0,5 Pa, die in einem Magnetron-HF-Kathodenzerstäubungsverfahren zur Abscheidung von Wismut-haltigen Eisengranatschichten eingesetzt wurden, um an etwa 12 Gew.% Wismut reichere Eisengranatschichten liefern als Argon-Plasmen eines Gesamtgasdrucks von 0,5 Pa. Dies führt zu einer Erhöhung der Werte für den Brechungsindex n einkristalliner und amorpher Schichten um bis zu 1,5% und zu einer Erhöhung der Werte für die Gitterkonstante $a_o$ von einkristallinen Schichten um bis zu 1,5%.

Nach einer vorteilhaften Ausgestaltung des Verfahrens nach der Erfindung werden Eisengranatschichten einer Zusammensetzung gemäß der allgemeinen Formel

$$(A,B)_3 (A,B)_5 O_{12}$$

mit
A = mindestens ein Seltenerdmetall, Bi,Pb und/oder Ca und
B = Ga,Al,Fe,Co,Ni,Mn,Ru,Ir,In und/oder Sc hergestellt.

Da der Epitaxieprozeß mittels Kathodenzerstäubung im Gegensatz zu z.B. Flüssigphasenepitaxieprozessen entfernt vom thermo-chemischen Gleichgewicht verläuft, ist auch die Herstellung von z.B. Granatschichten in Nicht-Gleichgewichtszusammensetzungen ohne Fremdphase möglich.

Es wurden beispielsweise aus ein und demselben Target einphasige Eisengranatschichten einkristallin mit folgenden Zusammensetzungen hergestellt:

$Gd_{2,04} Bi_{0,99} Fe_{4,15} Ga_{0,82} O_{12}$; $\qquad\qquad\qquad\qquad Gd_{2,08} Bi_{0,88} Fe_{4,21} Ga_{0,83} O_{12}$;

$Gd_{2,10} Bi_{0,87} Fe_{4,14} Ga_{0,89} O_{12}$; $Gd_{2,04} Bi_{0,92} Fe_{4,06} Ga_{0,98} O_{12}$; $\qquad Gd_{2,02} Bi_{0,97} Fe_{3,96} Ga_{1,05} O_{12}$ oder

$Gd_{2,12} Bi_{0,93} Fe_{4,14} Ga_{0,81} O_{12}$. Außerdem wurden einkristalline Eisengranatschichten mit folgenden Zusammensetzungen hergestellt: $Gd_{2,08} Bi_{1,12} Fe_{4,10} Al_{0,29} Ga_{0,41} O_{12}$ und $Gd_{2,13} Bi_{1,02} Fe_{4,02} Al_{0,38} Ga_{0,45} O_{12}$.

Nicht-kristalline (amorphe oder röntgenamorphe) Eisengranatschichten wurden mit folgenden Zusammensetzungen hergestellt:

$Gd_{2,14} Bi_{0,61} Fe_{4,38} Ga_{0,87} O_{12}$;

$Gd_{2,22} Bi_{0,40} Fe_{4,46} Ga_{0,92} O_{12}$;

$Gd_{2,24} Bi_{0,35} Fe_{4,42} Ga_{0,99} O_{12}$;

$Gd_{2,17} Bi_{0,36} Fe_{4,31} Ga_{1,16} O_{12}$;

$Gd_{2,15} Bi_{0,40} Fe_{4,22} Ga_{1,23} O_{12}$;

$Gd_{2,21} Bi_{0,48} Fe_{4,45} Ga_{0,86} O_{12}$ oder

$Gd_{1,35} Bi_{1,30} Fe_{4,80} Al_{0,26} Ga_{0,29} O_{12}$.

Nach weiteren vorteilhaften Ausgestaltungen des Verfahrens gemäß der Erfindung werden als Substrate (111)-orientierte nicht-magnetische Granat-Einkristallscheiben oder (110)-orientierte nicht-magnetische Einkristallscheiben, insbesondere aus Calcium-Magnesium-Zirkonium-substituiertem Gadolinium-Gallium-Granat der allgemeinen Formel $(Gd,Ca)_3 (Ga,Mg,Zr)_5 O_{12}$ eingesetzt.

Es können jedoch auch ebenso gut andere nicht-magnetische Gallium-Granat-Substrate eingesetzt werden.

Insbesondere mit der Verwendung einer (110)-orientierten Granat-Einkristallscheibe ist die Möglichkeit gegeben, optische Isolatoren mit einer spannungsinduzierten optischen Doppelbrechung in der Schichtebene herzustellen. Mittels Röntgen-Doppel-Kristall-Rocking-Kurven wurde festgestellt, daß auf einem derartigen Substrat abgeschiedene einkristalline Schichten eine gleich geringe Röntgenlinienbreite aufweisen, wie auf (111)-orientierten Substraten abgeschiedene Schichten sie aufweisen, auch wenn eine hohe Kristallgitter-Fehlanpassung (misfit) von größer als 1% zwischen Substrat und abgeschiedener einkristalliner Schicht vorliegt, was für optische Isolatoren mit semi-leaky-Eigenschaften von Bedeutung ist.

Wie bereits dargestellt, können nicht-kristalline (amorphe) und/oder einkristalline Eisengranatschichten aus z.B. ein und demselben Target abgeschieden werden. Die Ordnung der abgeschiedenen Schichten ist nicht nur abhängig von der Ordnung des Substrates sondern auch von der Substrattemperatur.

EP 0 352 857 B1

Es hat sich bei der Herstellung von optischen Wellenleitern auf der Basis von Eisengranatschichten mittels HF-Kathodenzerstäubung gezeigt, daß das Eisengranatmaterial auf einkristallinen Granat-Substraten einkristallin aufwächst, wenn die Substrate auf eine Temperatur oberhalb 470 °C aufgeheizt werden.

Bei Substrattemperaturen unter etwa 460 °C bilden sich nur amorphe bis röntgenamorphe (nicht-kristalline) Schichten aus, gleichgültig, ob das Substrat einkristallin ist oder in anderer Ordnung vorliegt. Wenn nur amorphe Schichten abgeschieden werden sollen, können beispielsweise auch Glassubstrate mit Vorteil eingesetzt werden.

Nach dem vorliegenden Verfahren kann nicht um eine einzelne einkristalline oder nicht-kristalline (= amorphe oder röntgenamorphe) Eisengranatschicht eines definierten Brechungsindex n und einer definierten Gitterkonstanten $a_o$ abgeschieden werden, sondern es ist auch möglich, aus ein und demselben Target in ein und demselben Prozeßschritt eine Folge von einkristallinen oder nicht-kristallinen Schichten jeweils eines unterschiedlichen Brechungsindex n und jeweils einer unterschiedlichen Gitterkonstanten $a_o$ abzuscheiden, auf diese Weise kann in der Schichtenfolge z.B. ein Brechungsindexprofil hergestellt werden, das als Stufenprofil oder auch als Gradientenprofil vorliegen kann. Nach einer vorteilhaften Weiterbildung des erfindungsgemäßen Verfahrens wird als Targetelektrode ein Magnetron, in das die für den Zerstäubungsprozeß erforderliche HF-Leistung eingespeist wird, eingesetzt. Ein Magnetron bewirkt, daß das Plasma in Targetnähe konzentriert und somit der Ionenbeschuß der wachsenden Schicht drastisch vermindert wird, so daß z.B. u.a. die das einkristalline Wachstum der Schicht beeinträchtigenden Rückstäubungseffekte minimiert werden. Bei Verwendung einer Magnetronelektrode ist es zweckmäßig, für das zu zerstäubende Target eine Phasenzusammensetzung zu wählen, die eine möglichst kleine Sättigungsmagnetisierung aufweist, um eine weitestgehende Konzentrierung des Plasmas in Targetnähe zu bewirken. Mit der Anwendung eines Magnetrons ist darüberhinaus der Vorteil verbunden, daß der Abstand zwischen Target und Substrat im Vergleich zu Verfahren, die mit HF-Kathodenzerstäubungsanlagen in Diodenanordnung arbeiten, optimiert werden kann im Sinne einer möglichst geringen Plasmadichte und kinetischen Energie in der Nähe des Substrats bei einer möglichst hohen Abscheidungsrate.

Das Verfahren nach der Erfindung weist folgende Vorteile auf: Einkristalline Eisengranatschichten mit einem für das nahe Infrarot definiert in einem Bereich von 2,1 bis 2,5 einstellbaren
Brechungsindex n und einer definiert in einem Bereich von 1,23 bis 1,28 einstellbaren Gitterkonstanten $a_o$ können neben nicht-kristallinen (amorphen) Eisengranatschichten eines definiert in einem Bereich von 2,1 bis 2,5 einstellbaren Brechungsindex n auf ein und demselben Substrat mit ein und derselben Vorrichtung und in einem einzigen Arbeitsgang hergestellt werden, wobei auch die Vorbereitung des Substrates vor Beginn des Beschichtungsprozesses in derselben Vorrichtung vorgenommen werden kann.

Für einen definierten Wellenlängenbereich, z.B. $\lambda$ = 1,2 bis 5,0 $\mu$m, läßt sich mit dem vorliegenden Verfahren der Brechungsindex n von Eisengranatschichten mit einer Genauigkeit von besser ± 0,05% in einer Variationsbreite von besser ± 1,0 % mit einer Reproduzierbarkeit von besser ± 0,02% einstellen. Dies ist ein großer Vorteil für eine wirtschaftlich arbeitende Großserienfertigung. Der jeweils gewünschte Brechungsindex n und die jeweils gewünschte Gitterkonstante $a_o$ lassen sich bis auf eine Genauigkeit von etwa ± 1,5% über die Zusammensetzung des Targets einstellen.

Vorteilhaft beim vorliegenden Verfahren ist z.B. für die Herstellung von einkristallinen Eisengranatschichten auf einem nicht-magnetischen einkristallinen Substrat auch, daß die Anpassung der Gitterkonstanten von Substrat und Schicht viel geringere Probleme bereitet, als z.B. bei einem Flüssigphasen-Epitaxieprozeß; Gitterfehlanpassungen von größer als 1% sind tolerierbar. Sie werden sogar in dieser Größenordnung gefordert, wenn z.B. optische Isolatoren mit semi-leaky-Eigenschaften hergestellt werden sollen.

Für die HF-Kathodenzerstäubung können im Handel erhältliche, mit HF-Spannung zu betreibende Kathodenzerstäubungsanlagen mit einer mit Magnetsystem ausgestatteten Targetkathode (Magnetron) benutzt werden, wobei eine Vorrichtung zur Messung der effektiven HF-Spannung sowohl an der Targetelektrode als auch an der Substratelektrode vorzusehen ist. Die Magnetronkathode ist liegend in einen herkömmlichen Vakuumrezipienten eingebaut.

Die für den Zerstäubungsprozeß erforderliche HF-Leistung wird vom HF-Generator über ein Impedanzanpassungsglied in die Targetelektrode eingespeist und so dem Plasma zugeführt. Die Konstanthaltung der HF-Spannung an der Targetelektrode auf Werte besser als ± 1% wird über eine Rechnersteuerung erreicht. Die Spannung an der Substratelektrode ist schwebend. Ebenfalls werden der Druck und die Zusammensetzung der Gasphase durch Rechnersteuerung auf besser als ± 1% konstant gehalten. Als Energiequelle für die Zerstäubungseinrichtung dient ein normaler HF-Generator, der bei einer Ausgangsleistung von 200 W betrieben wird. Die Betriebsfrequenz liegt bei 13,56 MHz.

Anhand der Zeichnung werden Ausführungsbeispiele der Erfindung beschrieben und in ihrer Wirkungsweise erläutert. Es zeigen:

Fig. 1       planarer Wellenleiter im Schnitt (Stand der Technik),

Fig. 2    graphische Darstellung des Brechungsindex n als Funktion des Drucks eines reinen Argonplasmas (Stand der Technik),

Fig. 3a,3b    graphische Darstellung von Brechungsindices n als Funktion eines Sauerstoff- bzw. eines Wasserstoffzusatzes zu einem Argonplasma (Erfindung),

Fig. 4    graphische Darstellung von Brechungsindices n als Funktion der Massenzahlen unterschiedlicher Edelgase (Erfindung).

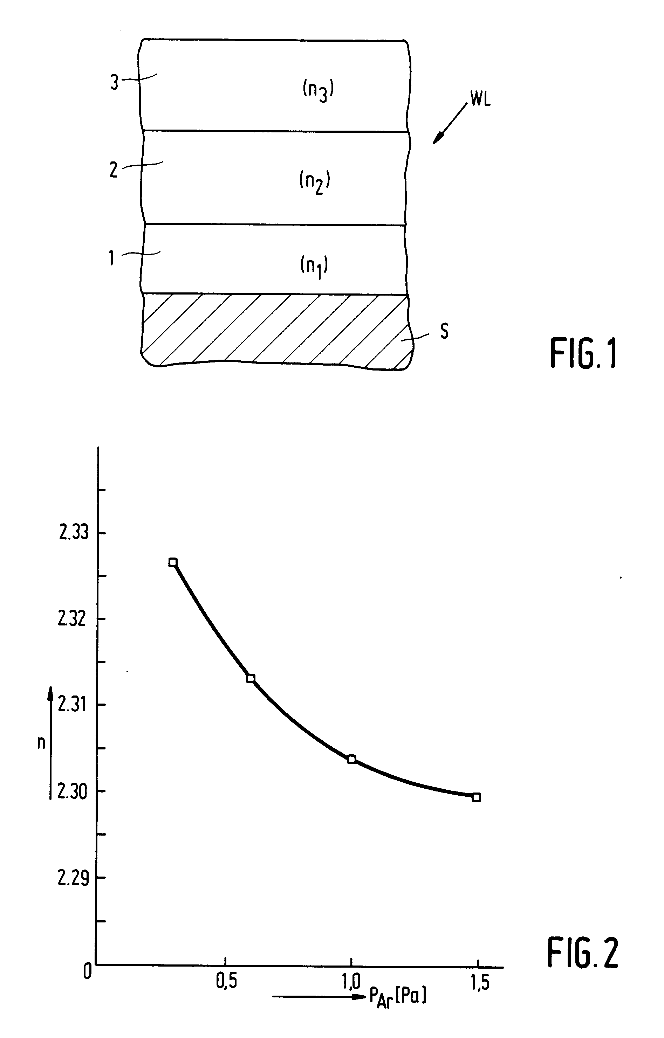

In Fig. 1 ist schematisch im Schnitt ein planarer Wellenleiter dargestellt, wie er aus dem Stand der Technik bekannt ist.

Mit WL ist der Wellenleiter bezeichnet, mit S das Substrat. Der dargestellte Wellenleiter besteht aus Materialien der Brechungsindices $n_1$, $n_2$ und $n_3$, wobei die Bedingung gilt: $n_1 > n_2 \approx n_3$. Die Schichten mit den Brechungsindices $n_1$ und $n_2$ sind einkristallin, die Schicht mit dem Brechungsindex $n_3$ ist amorph.

In Figur 2 ist der Brechungsindex n (für TE-polarisierte Moden, $\lambda$ = 1,285 $\mu$m) von einkristallinem, in situ auf einem (111)-orientierten einkristallinen nichtmagnetischen Granatsubstrat aus einem Target mit der Zusammensetzung (Angaben in Gew.%)

$Gd_2O_3$ 36,95 , $Bi_2O_3$ 25,65 , $Fe_2O_3$ 32,17 , $Ga_2O_3$ 3,79 und $Al_2O_3$ 1,44 abgeschiedenem Eisengranat als Funktion des Drucks eines reinen Argonplasmas aufgetragen.

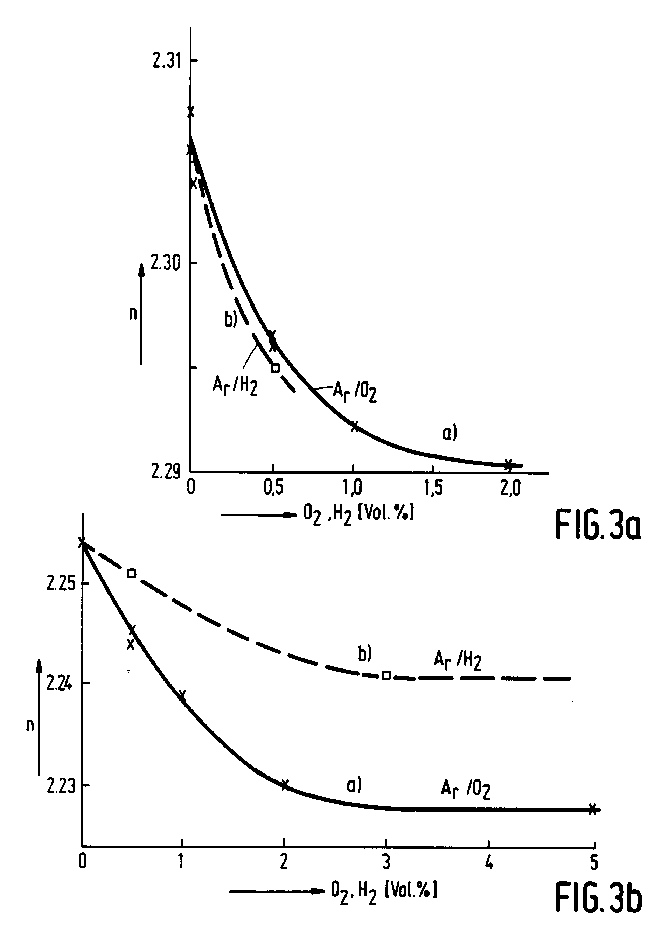

In Figur 3a ist der Brechungsindex n (für TE-polarisierte Moden, Wellenlänge $\lambda$ = 1,285 $\mu$m) von einkristallinem, in situ auf einem (111)-orientierten Gallium-Granat-Substrat aus einem Target mit der Zusammensetzung (Angaben in Gew.%)

$Gd_2O_3$ 34,44 , $Bi_2O_3$ 28,52 , $Fe_2O_3$ 30,91, $Ga_2O_3$ 6,13 abgeschiedenem Eisengranat als Funktion der Dotierung eines Argonplasmas mit Sauerstoff (Kurve a), Gesamtgasdruck

$$P_{ges} = P_{Ar} + P_{O_2} = 0,6 \ Pa,$$

bzw. als Funktion der Dotierung eines Argon-Plasmas mit Wasserstoff (Kurve b), Gesamtgasdruck

$$P_{ges} = P_{Ar} + P_{H_2} = 0,6 \ Pa,$$

aufgetragen.

In Figur 3b ist der Brechungsindex n (Wellenlänge $\lambda$ = 1,285 $\mu$m) von amorphem, in situ aus einem Target der Zusammensetzung (Angaben in Gew.%)

$Gd_2O_3$ 34,44 , $Bi_2O_3$ 28,52 , $Fe_2O_3$ 30,91 und $Ga_2O_3$ 6,13 abgeschiedenem Eisengranat als Funktion der Dotierung eines Argonplasmas mit Sauerstoff (Kurve a), Gesamtgasdruck

$$P_{ges} = P_{Ar} + P_{O_2} = 0,6 \ Pa,$$

bzw. als Funktion der Dotierung eines Argon-Plasmas mit Wasserstoff (Kurve b), Gesamtgasdruck

$$P_{ges} = P_{Ar} + P_{H_2} = 0,6 \ Pa,$$

aufgetragen. Für TM- und TE-polarisierte Moden ergeben sich im Rahmen der Meßgenauigkeit nahezu übereinstimmende Werte für den Brechungsindex n.

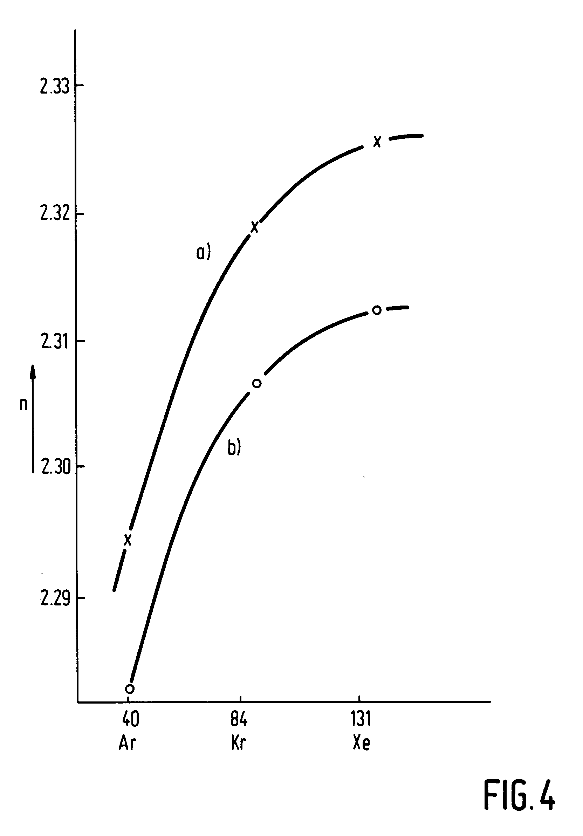

In Figur 4 ist der Brechungsindex n (für TE-polarisierte Moden, Wellenlänge $\lambda$ = 1,285 $\mu$m (Kurve a) und $\lambda$ = 1,538 $\mu$m (Kurve b)) von amorphem, in situ aus einem Target der Zusammensetzung (Angaben in Gew.%) $Gd_2O_3$ 32,34 , $Bi_2O_3$ 29,06 , $Fe_2O_3$ 35,66 , $Ga_2O_3$ 1,80 und $Al_2O_3$ 1,14 abgeschiedenem Eisengranat als Funktion der Massenzahl von Argon (40), Krypton (84) und Xenon (131) aufgetragen.

Als Ausführungsbeispiel wird die Herstellung eines planaren Wellenleiters für nicht-reziproke optische Bauelemente mit einkristallinen Schichten und sie bedeckendem Material anderer Ordnung (nicht-kristallin) aus Wismut-substituiertem Gadolinium-Eisen-Granat, bei dem ein Teil des Eisens durch Aluminium und Gallium substituiert ist, beschrieben.

Als Substrate wurden (111)-orientierte Calcium-Magnesium-Zirkonium-substituierte Gadolinium-Gallium-Granat-Einkristallscheiben eines Durchmessers von 30 mm verwendet, die vor dem Abscheidungsprozeß auf bekannte Weise derart vorbehandelt wurden, daß einkristallines Wachstum auf ihnen erfolgen kann. Auf diese Substrate wird zunächst mittels HF-Kathodenzerstäubung eine erste einkristalline Schicht eines

Brechungsindex $n_1$ aus Eisengranat aufgebracht. Diese Eisengranatschicht wird mit Hilfe desselben Targets abgeschieden, das zur späteren Herstellung einer weiteren einkristallinen Eisengranatschicht eines Brechungsindex $n_2$ eingesetzt wird. Dieser ersten Eisengranatschicht wird ein Brechungsindex $n_1$ erteilt, der größer ist, als der Brechungsindex $n_2$ der zweiten auf ihr später abzuscheidenden einkristallinen Schicht dadurch, daß entweder ein gegenüber den Bedingungen zur Abscheidung der zweiten einkristallinen Schicht niedrigerer Druck des Plasmas und/oder eine niedrigere Sauerstoff- oder Wasserstoffdotierung des Plasmas und/oder ein höherer Anteil von Edelgasen mit höherer Massenzahl als Argon im Plasma eingestellt wird.

Zur Abscheidung der ersten einkristallinen Eisengranatschicht eines Brechungsindex $n_1$ wird als Edelgas vorzugsweise Argon eines Drucks von 0,6 Pa in die bis zu einem Druck von kleiner als $10^{-3}$ Pa evakuierte Zerstäubungsapparatur eingeleitet. Eine solche Schicht mit einem Brechungsindex $n_1$, der größer ist als der der anschließend aufzubringenden zweiten einkristallinen Schicht eines Brechungsindex $n_2$ ist erforderlich, um einmodige Wellenleitung in dem herzustellenden Wellenleiter zu erreichen. Beispielsweise führt eine Veränderung des Sauerstoffanteils im Plasma von 0,45 Vol.% nach 1,0 Vol.% zu einem Brechungsindexsprung von etwa $5 \times 10^{-3}$ in der abgeschiedenen Schicht bei einer Targetzusammensetzung, wie sie unten angegeben ist. Für einmodige Wellenleitung ist es darüberhinaus erforderlich, die in einem mehrschichtig aufgebauten Wellenleiter laufenden Moden höherer Ordnung durch Aufbringen einer diese Moden absorbierenden Schicht wegzudämpfen. Für diese Absorberschicht eignet sich eine amorph abgeschiedene Eisengranatschicht mit einem an den Brechungsindex n der unterhalb der amorphen Eisengranatschicht liegenden einkristallinen Eisengranatschicht angepaßten Brechungsindex n.

Als Target (kathodische Zerstäubungsquelle) dient ein durch Heißpressen oder Sintern aus Eisengranat-Mischoxiden hergestellter Körper eines Durchmessers von 75 mm, einer Dicke von 4 mm und einer Porosität von kleiner als 10 % und vorzugsweise einer magnetischen Sättigungspolarisation $I_S$ kleiner als 3 mT.

Für das nachfolgende Ausführungsbeispiel werden Pulvergemische aus $BiFeO_3$, $BiGd_2Fe_5O_{12}$, $Al_2O_3$ und $Ga_2O_3$ in Sauerstoffatmosphäre eines Drucks von $10^5$ Pa über eine Dauer von 6 h bei einer Temperatur unterhalb 920 °C gesintert, wobei der Prozeß so geführt wird, daß kaum freies $Bi_2O_3$ im Keramikgefüge zurückbleibt.

Freies $Bi_2O_3$ soll deswegen nicht im Target vorhanden sein, weil es zur mechanischen Desintegration der Oberfläche des Targets durch seine gegenüber den anderen Targetbestandteilen erhöhte Zerstäubungsrate führt; durch die Verwendung von Mischoxiden wird eine Homogenisierung der Zerstäubungsrate aller Phasenbestandteile des Targets erreicht.

Zur Herstellung der ersten einkristallinen einphasigen Eisengranatschicht eines Brechungsindex $n_1$ = 2,3244 (für TE-polarisierte Moden, Wellenlänge $\lambda$ = 1,285 $\mu$m) und einer Gitterkonstanten $a_o$ = 1,2518 nm der Zusammensetzung $Gd_{2,08}Bi_{1,12}Fe_{4,10}Al_{0,29}Ga_{0,41}O_{12}$ wird ein Target folgender Zusammensetzung verwendet (Angaben in Gew.%):

| | |
|---|---|
| $Gd_2O_3$ | 36,95 |
| $Bi_2O_3$ | 25,65 |
| $Fe_2O_3$ | 32,17 |
| $Al_2O_3$ | 1,44 |
| $Ga_2O_3$ | 3,79 |

Der Targetkörper wird auf der Targetelektrode mit einem gut wärmeleitenden Kleber (z.B. mit Silberpulver gefülltes Epoxydharz) befestigt.

Um Verlustwärme abzuführen ist es zweckmäßig, z.B. durch Wasser, gekühlte Targetelektroden zu verwenden.

Der Abscheidungsprozeß wird so geführt, daß die Zerstäubungsapparatur zunächst mit einer Vakuumpumpe bis zu einem Druck von kleiner als $10^{-3}$ Pa evakuiert wird, anschließend wird Argon eines Drucks von 0,3 Pa eingeleitet. Der Abstand zwischen Target und Substrat beträgt 80 mm.

Die Niederschlagsrate liegt bei etwa 1,0 $\mu$m/h. Die an der HF-Zuleitung an der Rückseite der Targetelektrode gemessene HF-Spannung beträgt etwa 200 $V_{eff}$, das elektrische Potential an der Substratelektrode ist schwebend. Die Substrattemperatur beträgt 520 °C.

Eine zweite einkristalline einphasige Eisengranatschicht eines Brechungsindex $n_2$ = 2,3194 (für TE-polarisierte Moden, Wellenlänge $\lambda$ = 1,285 $\mu$m) und einer Gitterkonstanten $a_o$ = 1,2514 nm wird anschließend mittels desselben Targets und bis auf den Druck des Argonplasmas im übrigen gleichen Verfahrensparametern, wie zur Abscheidung der ersten einkristallinen Eisengranatschicht oben angegeben, abgeschieden. Der Druck des Argonplasmas zur Abscheidung der zweiten einkristallinen Eisengranatschicht beträgt 0,47 Pa. Damit wird ein Brechungsindexsprung $n_1$ nach $n_2 = 5 \times 10^{-3}$ eingestellt. Diese zweite einkristalline Schicht hat eine Zusammensetzung gemäß der Formel $Gd_{2,13}Bi_{,02}Fe_{4,02}Al_{,38}Ga_{0,45}O_{12}$.

Zur Herstellung einer nicht-kristallinen (amorphen) Eisengranatschicht eines Brechungsindex $n_3 = 2,3148$ (für TE-polarisierte Moden, Wellenlänge $\lambda = 1,285$ $\mu$m) der Zusammensetzung $Gd_{1,35}Bi_{1,30}Fe_{4,80}Al_{,26}Ga_{0,29}O_{12}$ wird ein Target folgender Zusammensetzung verwendet (Angaben in Gew.%):

| | |
|---|---|
| $Gd_2O_3$ | 32,34 |
| $Bi_2O_3$ | 29,06 |
| $Fe_2O_3$ | 35,66 |
| $Al_2O_3$ | 1,14 |
| $Ga_2O_3$ | 1,80. |

Der Targetkörper wird auf der Targetelektrode, wie oben beschrieben, befestigt. Der Beschichtungsprozeß wird ebenfalls wie oben beschrieben durchgeführt, die Substrattemperatur betrug jedoch 455 °C und es wurde eine Gasatmoshäre eines Gesamtdrucks $p_{ges} = 0,6$ Pa und einer Zusammensetzung aus 20 Vol.% Argon + 79,8 Vol.% Krypton + 0,2 Vol.% Sauerstoff eingesetzt.

Aus den nachfolgenden Tabellen ergibt sich, wie die Werte für den Brechungsindex n und die Gitterkonstante $a_o$ über den Druck und die Zusammensetzung des Plasmas gesteuert werden können.

Tabelle I gibt die Zusammensetzungen von Targets an, aus denen die in den Tabellen II und III aufgeführten Eisengranatschichten abgeschieden wurden; die Numerierung der Targets in den Tabellen I bis III stimmt überein. Tabelle II betrifft einkristalline, Tabelle III betrifft nicht-kristalline (amorphe) Eisengranatschichten.

Tabelle I

| Zusammensetzung | 1 | 2 | 3 | 4 |
|---|---|---|---|---|
| $Gd_2O_3$ | 34,44 | 32,34 | 27,71 | 36,95 |
| $Bi_2O_3$ | 28,52 | 29,06 | 42,06 | 25,65 |
| $Fe_2O_3$ | 30,91 | 35,66 | 27,48 | 32,17 |
| $Ga_2O_3$ | 6,13 | 1,80 | 1,53 | 3,79 |
| $Al_2O_3$ | - | 1,14 | 1,22 | 1,44 |
| | 100,00 | 100,00 | 100,00 | 100,00 |

7

Tabelle II
Einkristalline Schichten

| Target Nummer | Gaszusammensetzung $[$ Vol.% $]$ | | | | Gasdruck $[$ Pa $]$ | Brechungsindex n TE-MODEN $\lambda = 1,285$ µm | Gitterkonstante $a_o$ $[$ nm $]$ | Schichtenzusammensetzung $[$ Atome/Granatformel $]$ | | | | | Figur |
|---|---|---|---|---|---|---|---|---|---|---|---|---|---|
| | Ar | Kr | $O_2$ | $H_2$ | | | | Gd | Bi | Fe | Ga | Al | |
| 1 | 100 | - | - | - | 0,6 | 2,3061 | 1,2551 | 2,04 | 0,99 | 4,15 | 0,82 | - | 3a |
| | 99,5 | - | 0,5 | - | 0,6 | 2,2965 | 1,2532 | 2,08 | 0,88 | 4,21 | 0,83 | - | |
| | 99,0 | - | 1,0 | - | 0,6 | 2,2921 | 1,2530 | 2,10 | 0,87 | 4,14 | 0,89 | - | |
| | 98,0 | - | 2,0 | - | 0,6 | 2,2904 | 1,2529 | 2,04 | 0,92 | 4,06 | 0,98 | - | |
| | 95,0 | - | 5,0 | - | 0,6 | 2,2918 | * | 2,02 | 0,97 | 3,96 | 1,05 | - | |
| | 99,5 | - | - | 0,5 | 0,6 | 2,2949 | 1,2547 | 2,12 | 0,93 | 4,14 | 0,81 | - | |
| 2 | - | 100 | - | - | 0,6 | 2,3675 | 1,2579 | * | * | * | * | * | |
| | 100 | - | - | - | 0,6 | 2,3524 | 1,2571 | * | * | * | * | * | |
| 4 | 100 | - | - | - | 0,3 | 2,3244 | 1,2518 | 2,08 | 1,12 | 4,10 | 0,41 | 0,29 | 2 |
| | 100 | - | - | - | 0,47 | 2,3194 | 1,2514 | 2,13 | 1,02 | 4,02 | 0,45 | 0,38 | |

* nicht bestimmt

EP 0 352 857 B1

**Tabelle III**
**Nicht-kristalline Schichten**

| Target Nummer | Figur | Al | Ga | Fe | Bi | Gd | Brechungsindex n TE-MODEN $\lambda = 1,285\ \mu m$ | Gasdruck [Pa] | H$_2$ | O$_2$ | Xe | Kr | Ar |
|---|---|---|---|---|---|---|---|---|---|---|---|---|---|
| 1 | 3b | - | 0,87 | 4,31 | 0,61 | 2,14 | 2,2541 | 0,6 | - | - | - | - | 100 |
|  |  | - | 0,92 | 4,46 | 0,40 | 2,22 | 2,2453 | 0,6 | - | 0,5 | - | - | 99,5 |
|  |  | - | 0,99 | 4,42 | 0,35 | 2,24 | 2,2390 | 0,6 | - | 1,0 | - | - | 99,0 |
|  |  | - | 1,16 | 4,31 | 0,36 | 2,17 | 2,2298 | 0,6 | - | 2,0 | - | - | 98,0 |
|  |  | - | 1,23 | 4,22 | 0,40 | 2,15 | 2,2272 | 0,6 | - | 5,0 | - | - | 95,0 |
|  |  | - | 0,86 | 4,45 | 0,48 | 2,21 | 2,2504 | 0,6 | 0,5 | - | - | - | 99,5 |
| 3 |  | 0,33 | 0,20 | 4,20 | 2,09 | 1,18 | 2,3335 | 0,5 | - | - | - | 100 | - |
|  |  | 0,28 | 0,19 | 4,00 | 1,87 | 1,66 | 2,2723 | 0,5 | - | - | - | - | 100 |
| 2 | 4 | * | * | * | * | * | 2,2947 | 0,6 | - | - | - | - | 100 |
|  |  | * | * | * | * | * | 2,3191 | 0,6 | - | - | - | 100 | - |
|  |  | * | * | * | * | * | 2,3257 | 0,6 | - | - | 100 | - | - |
|  |  | 0,26 | 0,29 | 4,80 | 1,30 | 1,35 | 2,3148 | 0,6 | - | 0,2 | - | 79,8 | 20 |

Schichtenzusammensetzung [Atome/Granatformel]

Gaszusammensetzung [Vol.%]

* nicht bestimmt

## Patentansprüche

1. Verfahren zur Herstellung von Eisengranatschichten mit in geringer Schwankungsbreite reproduzierbar eingestellten Brechungsindices n und Gitterkonstanten $a_0$, wobei die schichten mittels HF-Kathodenzerstäubung unter Verwendung eines überwiegend eine Eisengranatphase neben Restphasen nahezu gleicher Zerstäubungsrate enthaltenden Targets in einem Edelgasplasma einer Ionenenergie der die anwachsende Schicht bombardierenden Ionen von kleiner als $10^2$ eV und eines Drucks im Bereich von 0,1 bis 2,0 Pa auf einem Substrat abgeschieden werden,
dadurch gekennzeichnet,
daß das Edelgas mit bis zu 5 Vol.% mindestens eines reaktiven Gases dotiert wird.

2. Verfahren nach Anspruch 1,
dadurch gekennzeichnet,

9

daß das Edelgas mit bis zu 2 Vol.% mindestens eines reaktiven Gases dotiert wird.

**3.** Verfahren nach den Ansprüchen 1 und 2,
dadurch gekennzeichnet,
daß als Edelgas mindestens eines der Gase Argon, Krypton oder Xenon eingesetzt wird.

**4.** Verfahren nach mindestens einem der Ansprüche 1 bis 3,
dadurch gekennzeichnet,
daß als reaktives Gas Sauerstoff eingesetzt wird.

**5.** Verfahren nach mindestens einem der Ansprüche 1 bis 3,
dadurch gekennzeichnet,
daß als reaktives Gas Wasserstoff eingesetzt wird.

**6.** Verfahren nach mindestens einem der Ansprüche 1 bis 5,
dadurch gekennzeichnet,
daß der Gesamtgasdruck auf einen Wert im Bereich von 0,3 bis 1,0 Pa eingestellt wird.

**7.** Verfahren nach mindestens einem der Ansprüche 1 bis 6,
dadurch gekennzeichnet,
daß die Eisengranatschicht eine Zusammensetzung gemäß der allgemeinen Formel $(A,B)_3 (A,B)_5 0_{12}$ hat mit
A = mindestens ein Seltenerdmetall, Bi,Pb und/oder Ca und
B = Ga,Al,Fe,Co,Ni,Mn,Ru,Ir,In und/oder Sc.

**8.** Verfahren nach mindestens einem der Ansprüche 1 bis 7,
dadurch gekennzeichnet,
daß als Substrat eine (111)-orientierte nicht-magnetische Granat-Einkristallscheibe eingesetzt wird.

**9.** Verfahren nach mindestens einem der Ansprüche 1 bis 7,
dadurch gekennzeichnet,
daß als Substrat eine (110)-orientierte nicht-magnetische Granat-Einkristallscheibe eingesetzt wird.

**10.** Verfahren nach den Ansprüchen 8 und 9,
dadurch gekennzeichnet,
daß als Substrat Calcium-Magnesium-Zirkonium-substituierter Gadolinium-Gallium-Granat $(Gd,Ca)_3$-$(Ga,Mg,Zr)_5 0_{12}$ eingesetzt wird.

**11.** Verfahren nach mindestens einem der Ansprüche 1 bis 10,
dadurch gekennzeichnet,
daß die Eisengranatschicht(en) einkristallin abgeschieden wird(werden).

**12.** Verfahren nach Anspruch 11,
dadurch gekennzeichnet,
daß die einkristalline Eisengranatschicht als Schichtenfolge einzelner einkristalliner Schichten eines jeweils unterschiedlichen Brechungsindex n und einer jeweils unterschiedlichen Gitterkonstanten $a_o$ abgeschieden wird.

**13.** Verfahren nach mindestens einem der Ansprüche 1 bis 10,
dadurch gekennzeichnet,
daß die Eisengranatschicht(en) nicht-kristallin abgeschieden wird(werden).

**14.** Verfahren nach Anspruch 13,
dadurch gekennzeichnet,
daß die nicht-kristalline Eisengranatschicht als Schichtenfolge einzelner nicht-kristalliner Schichten eines jeweils unterschiedlichen Brechungsindex n abgeschieden wird.

EP 0 352 857 B1

**15.** Verfahren nach den Ansprüchen 11 und 12,
dadurch gekennzeichnet,
daß das Substrat während des Schichtabscheidungsprozesses auf eine Temperatur oberhalb von 470 °C aufgeheizt wird.

**16.** Verfahren nach den Ansprüchen 13 und 14,
dadurch gekennzeichnet,
daß das Substrat auf eine Temperatur unterhalb von 460 °C aufgeheizt wird.

**17.** Verfahren nach mindestens einem der Ansprüche 1 bis 16,
dadurch gekennzeichnet,
daß als Targetelektrode ein Magnetron, in das die für den Zerstäubungsprozeß erforderliche HF-Leistung eingespeist wird, eingesetzt wird.

## Claims

**1.** A method of manufacturing iron garnet layers having refractive indices n and lattice constants $a_o$ which can be reproducibly adjusted in a narrow varuation rage, in which method the layers are deposited on a substrate by means of rf cathode sputtering using a target comprising predominantly a iron garnet phase, besides residual phases having substantially equal sputtering rates, in a noble gas plasma having an ion energy of the ions bombarding the growing layer of less than $10^2$ eV and a pressure in the rage from 0.1 to 2.0 Pa, characterized in that the noble gas is doped with up to 5% by volume of at least one reactive gas.

**2.** A method as claimed in Claim 1, characterized in that the noble gas is doped with up to 2% by volume of at least one reactive gas.

**3.** A method as claimed in Claims 1 and 2, characterized in that at least one of the gases argon, crypton or xenon is used as the noble gas.

**4.** A method as claimed in at least one of the Claims 1 to 3, characterized in that oxygen is used as a reactive gas.

**5.** A method as claimed in at least one of the Claims 1 to 3, characterized in that hydrogen is used as a reactive gas.

**6.** A method as claimed in at least one of the Claims 1 to 5, characterized in that the overall pressure is adjusted at a value in the rage from 0.3 to 1.0 Pa.

**7.** A method as claimed in at least one of the Claims 1 to 6, characterized in that the iron garnet layer has a composition according to the general formula

$$(A, B)_3 \ (A, B)_5 O_{12},$$

where
A = at least a noble earth metal, Bi, Pb and/or Ca and
B = Ga, Al, Fe, Co, Ni, Mn, Ru, Ir, In and/or Sc.

**8.** A method as claimed in at least one of the Claims 1 to 7, characterized in that a (111)-oriented non-magnetic garnet mono-crystalline disc is used as a substrate.

**9.** A method as claimed in at least one of the Claims 1 to 7, characterized in that a (110)-oriented non-magnetic garnet monocrystalline disc is used as a substrate.

**10.** A method as claimed in Claims 8 and 9, characterized in that calcium-magnesium-zirconium-substituted gadolinium-gallium garnet $(Gd, Ca)_3 (Ga, Mg, Zr)_5 O_{12}$ is used as a substrate.

11

**11.** A method as claimed in at least one of the Claims 1 to 10, characterized in that the iron garnet layer(s) is (are) deposited in a monocrystalline manner.

**12.** A method as claimed in Claim 11, characterized in that the monocrystalline iron garnet layer is deposited as a succession of individual monocrystalline layers of different refractive indices $\underline{n}$ and different lattice constants $a_o$.

**13.** A method as claimed in at least one of the Claims 1 to 10, characterized in that the iron garnet layer(s) is (are) deposited in a non-crystalline manner.

**14.** A method as claimed in Claim 13, characterized in that the non-crystalline iron garnet layer is deposited as a succession of individual non-crystalline layers of different refractive indices $\underline{n}$.

**15.** A method as claimed in Claims 11 and 12, characterized in that during the layer deposition process the substrate is heated to a temperature above 470° C.

**16.** A method as claimed in Claims 13 and 14, characterized in that the substrate is heated to a temperature below 460° C.

**17.** A method as claimed in at least one of the Claims 1 to 16, characterized in that a magnetron into which the rf power required for the sputtering process is fed is used as the target electrode.

**Revendications**

**1.** Procédé pour la fabrication de couches de grenat de fer présentant des indices de réfraction n ainsi que des constantes de réseau $a_0$ ajustés de manière reproductible dans les limites d'un faible domaine de variation, les couches étant déposées sur un substrat par pulvérisation cathodique à haute fréquence en utilisant une cible contenant sensiblement une phase de grenat de fer ainsi que des phases résiduaires formées à peu près à la même vitesse de pulvérisation, dans un plasma de gaz noble d'une énergie ionique inférieure à 102 eV fournie par les ions bombardant la couche croissante, ainsi qu'une pression située dans l'intervalle compris entre 0,1 et 2,0 Pa, caractérisé en ce que le gaz noble est dopé tout au plus de 5% en volume d'au moins un gaz réactif.

**2.** Procédé selon la revendication 1, caractérisé en ce que le gaz noble est dopé tout au plus de 2% en volume d'au moins un gaz réactif.

**3.** Procédé selon les revendications 1 et 2, caractérisé en ce que comme gaz noble on utilise au moins l'un des gaz d'argon, de krypton ou de xénon.

**4.** Procédé selon l'une des revendications 1 à 3, caractérisé en ce que l'on utilise l'oxygène comme gaz réactif.

**5.** Procédé selon au moins l'une des revendications 1 à 3, caractérisé en ce que l'on utilise l'hydrogène comme gaz réactif.

**6.** Procédé selon l'une quelconque des revendications 1 à 5, caractérisé en ce que la pression de gaz totale est ajustée sur une valeur située dans l'intervalle allant de 0,3 à 1,0 Pa.

**7.** Procédé selon au moins l'une des revendications 1 à 6, caractérisé en ce que la couche de grenat de fer présente une composition correspondant à la formule générale

$(A, B)_3 \ (A, B)_5 O_{12}$

où
A = au moins un métal de terre rare, Bi, Pb et/ou Ca et
B = Ga, Al, Fe, Co, Ni, Mn, Ru, Ir, In et/ou Sc.

**8.** Procédé selon au moins l'une des revendications 1 à 7, caractérisé en ce que l'on utilise comme substrat un disque monocristallin de grenat non magnétique à orientation (111).

**9.** Procédé selon au moins l'une des revendications 1 à 7, caractérisé en ce que l'on utilise comme substrat un disque monocristallin de grenat non magnétique à orientation (110).

**10.** Procédé selon les revendications 8 et 9, caractérisé en ce que l'on utilise comme substrat le grenat de gadolinium et de gallium $(Gd, Ca)_3(Ga, Mg, Zr)_5O_{12}$ à substitution de calcium, de magnésium et de zirconium.

**11.** Procédé selon au moins l'une des revendications 1 à 10, caractérisé en ce que la (les) couche(s) de grenat de fer est (sont) déposée(s) de façon monocristalline.

**12.** Procédé selon la revendication 11, caractérisé en ce que la couche de grenat de fer monocristalline est déposée sous forme d'une succession de couches monocristallines individuelles présentant chacune un indice de réfraction n ainsi qu'une constante de réseau $a_0$ différents.

**13.** Procédé selon au moins l'une des revendications 1 à 10, caractérisé en ce que la (les) couche(s) de grenat de fer est (sont) déposée(s) de façon non cristalline.

**14.** Procédé selon la revendication 13, caractérisé en ce que la couche de grenat de fer non cristalline est déposée sous forme d'une succession de couches non cristallines individuelles présentant chacune un indice de réfraction n différent.

**15.** Procédé selon les revendications 11 et 12, caractérisé en ce que pendant le procédé de dépôt de la couche le substrat est chauffé à une température supérieure à 470°C.

**16.** Procédé selon les revendications 13 et 14, caractérisé en ce que le substrat est chauffé à une température inférieure à 460°C.

**17.** Procédé selon l'une quelconque des revendications 1 à 16, caractérisé en ce que l'on utilise comme électrode de cible un magnétron auquel est appliquée la puissance haute fréquence indispensable pour le procédé de pulvérisation.

FIG.1

FIG.2

FIG.3a

FIG.3b

FIG.4